# EUROPEAN PATENT SPECIFICATION

(11) **EP 3 160 070 B1**
(45) Date of publication and mention of the grant of the patent: **19.05.2021**
(21) Application number: 14896157.6
(22) Date of filing: 05.09.2014
(51) Int. Cl.: H04L 1/00, H03M 13/25, H03M 13/29, H03M 13/35, H03M 13/11, H03M 13/15, H03M 13/23

(54) **MULTI-STAGE ENCODING DEVICE, METHOD FOR IMPLEMENTING MULTI-STAGE ENCODING DEVICE AND STORAGE MEDIUM**
MEHRSTUFIGE CODIERUNGSVORRICHTUNG, VERFAHREN ZUR IMPLEMENTIERUNG EINER MEHRSTUFIGEN CODIERUNGSVORRICHTUNG UND SPEICHERMEDIUM
DISPOSITIF D'ENCODAGE MULTI-ÉTAGE MULTIPLES, PROCÉDÉ POUR LA MISE EN OEUVRE D'UN DISPOSITIF D'ENCODAGE MULTI-ÉTAGE ET SUPPORT DE STOCKAGE

(30) Priority: 26.06.2014 CN 201410298875
(43) Date of publication of application: 26.04.2017
(73) Proprietor: Sanechips Technology Co., Ltd., Shenzhen, Guangdong 518055 (CN)
(72) Inventor: ZHANG, Bingfeng, Shenzhen, Guangdong 518055 (CN); SHI, Lei, Shenzhen, Guangdong 518055 (CN)
(74) Representative: Aipex B.V.
(86) International application number: PCT/CN2014/085991
(87) International publication number: WO 2015/196565

(56) References cited:
- EP-A1- 1 667 350
- EP-A2- 0 820 159
- CN-A- 1 229 554
- CN-A- 1 825 917
- CN-A- 102 474 496
- CN-A- 103 391 170
- US-A1- 2002 150 167
- US-A1- 2003 101 407
- US-B1- 8 719 670
- ARDAKANI M ET AL: "Near-Capacity Coding in Multicarrier Modulation Systems", IEEE TRANSACTIONS ON COMMUNICATIONS, IEEE SERVICE CENTER, PISCATAWAY, NJ. USA, vol. 52, no. 11, 1 November 2004 (2004-11-01), pages 1880-1889, XP011122045, ISSN: 0090-6778, DOI: 10.1109/TCOMM.2004.836560

## Description

### TECHNICAL FIELD

The disclosure relates to data transmission technology in a microwave communication system, and in particular to a multi-stage encoding device, a method for implementing the multi-stage encoding device and a storage medium.

### BACKGROUND

Microwave communication, together with optical fibre communication and satellite communication, is considered as three main means of modern communication transmission; and the microwave communication adopts generally a point-to-point transmission mode, with applied mainly to a 2G/3G mobile carrying network, to provide speech and data service transmission for mobile operators, and is characterized by a large transmission capacity, a stable quality of transmission, a low investment, a short construction cycle, and maintenance convenience and so on.

An encoding scheme in the microwave communication can be implemented through Low Density Parity Check Code (LDPC) encoding or Reed-Solomon code (RS) encoding; the LDPC encoding has advantages of good performance of approaching the Shannon limit, a low decoding complexity, and a flexible structure and so on, but an error floor occurs easily in the LDPC encoding; the RS encoding is a low-speed channel encoding of forward error correction and is only valid for a multinomial generated by corrected sampled data. A convolutional code encoding is to encode continuously input information sequences so as to obtain continuously output encoded sequences; a Turbo code encoding can perform subtly a parallel concatenation on two simple component codes through a pseudorandom interleaver so as to construct them as a long code with a pseudorandom characteristic. Each of the encoding modes has respective advantages and disadvantages, so a problem to be solved is to provide an encoding mode that improves encoding efficiency and reliability.

ARDAKANI MET AL (IEEE TRANSACTIONS ON COMMUNICATIONS, VOL. 52, NO. 11, NOVEMBER 2004) discloses near-capacity coding in multicarrier modulation systems. ARDAKANI MET apply irregular low-density parity-check (LDPC) codes to the design of multilevel coded quadrature amplitude modulation (QAM) schemes for application in discrete multitone systems in frequency-selective channels.

US-A-2002/0150167 discloses methods and apparatus for configurable or assymetric forward error correction. The encoder of a communication device is configurable such that the encoder may operate in any of a variety of forward error correction modes. Further, for each mode, a variety of encoding parameters may be configured. The configurability of forward error correction modes and/or parameters enables communication devices to perform interactive configuration processes, whereby a communicating device specifies the type of forward error correction that the other is to perform. This configuration may be bidirectional, such that each device selects the forward error correction provided by the other. Each device may further configure its decoder to decode the forward error correction mode that it has selected for the other communication device. In other embodiments two communicating devices may implement two different modes of forward error correction.

US-A-2003/0101407 discloses Selectable complexity turbo coding system. A switchable-output encoder for encoding an input data sequence into an error protection encoded output sequence is switchable between two encoding modes. The encoder modes comprise a relatively complex mode suitable for a relatively high noise level channel and a relatively simple mode suitable for a relatively low noise level channel. A corresponding decoder is also discussed.

EP-A-1667350 discloses a signal transmission method in a radio multiplex transmission system. The method comprises the steps of: serial-to-parallel converting serial data to be transmitted into N (N: two or more) parallel data series; independently performing an error-correcting encoding process on the parallel signals of the N data series serial-to-parallel converted; parallel-to-serial converting the parallel signals encoded with error-correcting codes; performing an interleaving process on the parallel-to-serial converted signals; serial-to-parallel converting the interleaved signals into L (L: two or more) parallel data series and transmitting each of the L data series using L antennas; receiving the transmitted signals; separating the received signals into M (M: two or more) data series and parallel-to-serial converting the M data series; performing a deinterleaving process on the parallel-to-serial converted signals; serial-to-parallel converting the deinterleaved signals into N data series; independently performing an error-correcting decoding process on the parallel signals of the N data series serial-to-parallel converted; and parallel-to-serial converting the signals in which the error-correcting codes are decoded, thereby recovering the transmitted data.

### SUMMARY

In view of this, embodiments of the disclosure are desired to provide a multi-stage encoding device, a method for implementing the multi-stage encoding device and a storage medium, which can improve the encoding efficiency and reliability.

The technical solutions of the embodiments of the disclosure are implemented as follows.

An embodiment of the disclosure provides a multi-stage encoding device as specified in the appended claims 1-6 and a method for implementing a multi-stage encoding device as specified in claims 7-11.

An embodiment of the disclosure further provides a computer storage medium in which a computer executable instruction is stored for performing the method for implementing the multi-stage encoding device as specified in claims 7 to 11.

According to the multi-stage encoding device, the method for implementing the multi-stage encoding device and the storage medium provided by the embodiments of the disclosure, the input selection switch and the output selection switch are provided between input and output ends of two encoders, and the two encoders are enabled to encode in parallel or in series by controlling the output selection switch and the input selection switch; or for multiple encoders, the input selection switch and the output selection switch are provided between the input end and the output end of every two neighboring encoders respectively, and the multiple encoders are enabled to encode in parallel or in series by controlling each output selection switch and each input selection switch; in this way, parallel encoding or serial encoding can be made among multiple encoders by controlling the on/off state of each input selection switch and each output selection switch or the selection of the input end, so the weakness under a condition that a single encoder performs the encoding can be remedied, and thus the encoding efficiency and reliability can be improved.

### BRIEF DESCRIPTION OF THE DRAWINGS

Fig. 1 is a schematic diagram of composition structure of a multi-stage encoding device according to an embodiment of the disclosure;
Fig. 2 is a schematic diagram of composition structure of another multi-stage encoding device according to an embodiment of the disclosure;
Fig. 3 is a schematic diagram of composition structure of yet another multi-stage encoding device according to an embodiment of the disclosure;
Fig. 4 is a schematic diagram of a basic implementation flow of a method for implementing a multi-stage encoding device according to an embodiment of the disclosure;
Fig. 5 is a schematic diagram of a constellation map of 64qam (0, 4) according to an embodiment of the disclosure;
Fig. 6 is a schematic diagram of a basic flow of connecting an RS encoder and an LDPC encoder in parallel and mapping the encoded data according to an embodiment of the disclosure;
Fig. 7 is a schematic diagram of a detailed implementation flow of connecting an RS encoder and an LDPC encoder in parallel and mapping the encoded data according to an embodiment of the disclosure;
Fig. 8 is a schematic diagram of a constellation map of qpsk (0, 2) according to an embodiment of the disclosure;
Fig. 9 is a schematic diagram of a constellation map of 64qam (4, 2) according to an embodiment of the disclosure;
Fig. 10 is a schematic diagram of a basic implementation flow of another method for implementing a multi-stage encoding device according to an embodiment of the disclosure; and
Fig. 11 is a schematic diagram of an implementation flow of connecting an RS encoder, a Convolution encoder and an LDPC encoder in parallel and mapping the encoded data according to an embodiment of the disclosure.

### DETAILED DESCRIPTION

In an embodiment of the disclosure, an input selection switch and an output selection switch are provided between input and output ends of two encoders, and these two encoders are enabled to encode in parallel or in series by controlling the output selection switch and the input selection switch; or for multiple encoders, the input selection switch and the output selection switch are provided between the input end and the output end of every two neighboring encoders respectively, and the multiple encoders are enabled to encode in parallel or in series by controlling each output selection switch and each input selection switch.

Here, the encoders include, but are not limited to, a RS encoder, a LDPC encoder, a convolution encoder and a Turbo encoder.

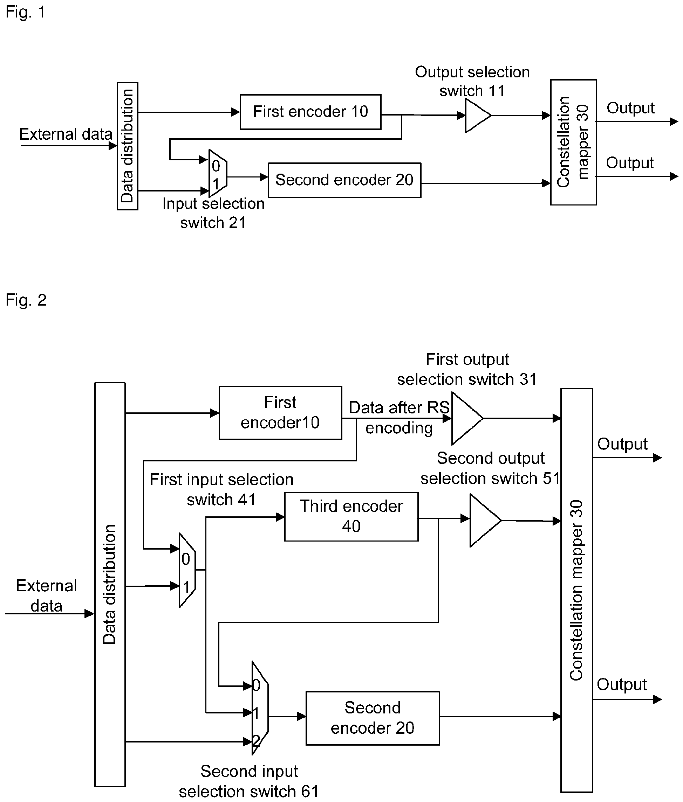

As shown in Fig. 1, the composition structure of a multi-stage encoding device in an embodiment of the disclosure includes a first encoder 10 and a second encoder 20;
an input end of the first encoder 10 is connected to a data input end, an output end of the first encoder 10 is connected to a constellation map mapper via an output selection switch 11, and the output end of the first encoder 10 is connected to a first input end of an input selection switch 21;
a second input end of the input selection switch 21 is connected to the data input end, and an output end of the input selection switch 21 is connected to an input end of the second encoder 20; an output end of the second encoder 20 is connected to a constellation map mapper 30; and
an on/off state of the output selection switch 11 enables the input selection switch 21 to switch on different input ends.

In an embodiment, when the output selection switch 11 is in an on state, the input selection switch 21 switches the second input end on, and the first encoder 10 and the second encoder 20 are connected in parallel.

In an embodiment, when the output selection switch 11 is in an off state, the input selection switch 21 switches the first input end on, and the first encoder 10 and the second encoder 20 are connected in series.

In an embodiment, the first encoder 10 is the RS encoder, and the second encoder 20 is the LDPC encoder.

As shown in Fig. 2, the composition structure of another multi-stage encoding device in an embodiment of the disclosure includes a first encoder 10, a second encoder 20 and at least one third encoder 40;
the input end of the first encoder 10 is connected to the data input end, the output end of the first encoder 10 is connected to the constellation map mapper 30 via the first output selection switch 31, and the output end of the first encoder 10 is connected to a first input end of a first input selection switch 41 ;
the second input end of the first input selection switch 41 is connected to the data input end, and the output end of the first input selection switch 41 is connected to an input end of the third encoder 40 and a second input end of a second input selection switch 61; an output end of the third encoder 40 is connected to the constellation map mapper 30 via a second output selection switch 51, and the output end of the third encoder 40 is connected to a first input end of the second input selection switch 61;
a third input end of the second input selection switch 61 is connected to the data input end, an output end of the second input selection switch 61 is connected to an input end of the second encoder 20, and an output end of the second encoder 20 is connected to the constellation map mapper 30;
an on/off state of the first output selection switch 31, an on/off state of the second output selection switch 51 and different input ends switched on by the first input selection switch 41 enable the second input selection switch 61 to switch on different input ends;
an on/off state of the second output selection switch 51 and different input ends switched on by the first input selection switch 41 enable the second input selection switch 61 to switch on different input ends.

In an embodiment, when the first output selection switch 31 is in the on state, the first input selection switch 41 switches the second input end on, the second output selection switch 51 is in an on state, the second input selection switch 61 switches the third input end on, and the first encoder 10, the second encoder 20 and the third encoder 40 are connected in parallel.

In an embodiment, when the first output selection switch 31 is in the off state, the first input selection switch 41 switches the first input end on, the second output selection switch 51 is in the on state, the second input selection switch 61 switches the third input end on, the first encoder 10 and the third encoder 40 are connected in series with each other and are connected in parallel with the second encoder 20.

In an embodiment, when the first output selection switch 31 is in the off state, the first input selection switch 41 switches the first input end on, the second output selection switch 51 is in the off state, the second input selection switch 61 switches the first input end on, and the first encoder 10, the second encoder 20 and the third encoder 40 are connected in series.

In an embodiment, when the first output selection switch 31 is in the on state, the first input selection switch 41 switches the second input end on, the second output selection switch 51 is in the off state, the second input selection switch 61 switches the first input end on, and the second encoder 20 and the third encoder 40 are connected in series with each other and are connected in parallel with the first encoder 10.

In an embodiment, when the first output selection switch 31 is in the off state, the first input selection switch 41 switches the first input end on, the second output selection switch 51 is in the off state, the second input selection switch 61 switches the second input end on, and the first encoder 10 and the second encoder 20 are connected in series.

In an embodiment, when the first output selection switch 31 is in the on state, the first input selection switch 41 switches the second input end on, the second output selection switch 51 is in the off state, the second input selection switch 61 switches the third input end on, and the first encoder 10 and the second encoder 20 are connected in parallel.

In an embodiment, when the first output selection switch 31 is in the off state, the first input selection switch 41 switches the second input end on, the second output selection switch 51 is in the off state, the second input selection switch 61 switches the first input end on, and the second encoder 20 and the third encoder 40 are connected in series.

In an embodiment, when the first output selection switch 31 is in the off state, the first input selection switch 41 switches the second input end on, the second output selection switch 51 is in the on state, the second input selection switch 61 switches the third input end on, and the second encoder 20 and the third encoder 40 are connected in parallel.

In an embodiment, when the first output selection switch 31 is in the off state, the first input selection switch 41 switches the first input end on, the second output selection switch 51 is in the on state, the second input selection switch 61 switches the first input end or the second input end on, and the first encoder 10 and the third encoder 40 are connected in series.

In an embodiment, when the first output selection switch 31 is in the on state, the first input selection switch 41 switches the second input end on, the second output selection switch 51 is in the on state, the second input selection switch 61 switches the first input end or the second input end on, and the first encoder 10 and the third encoder 40 are connected in parallel.

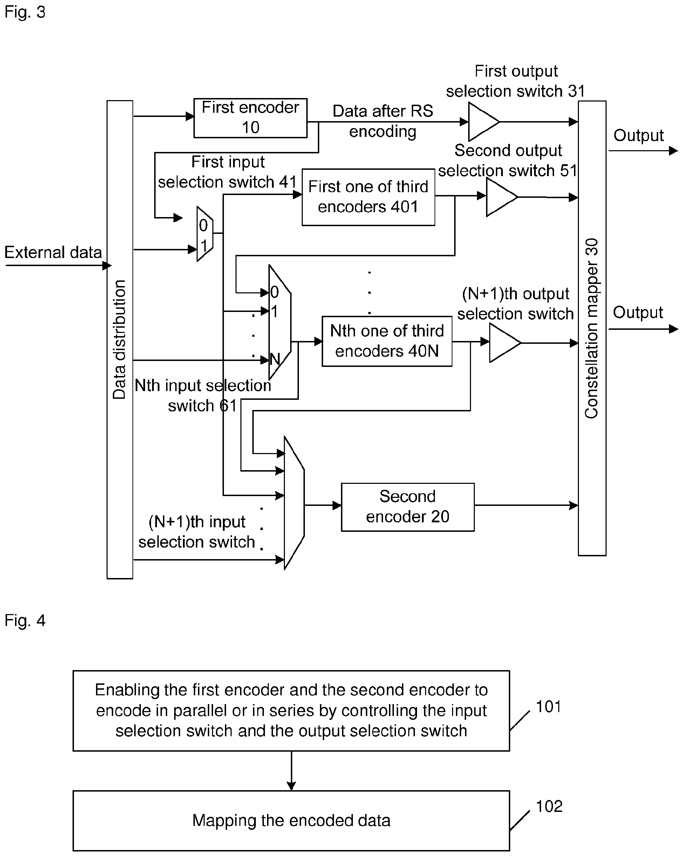

In an embodiment, the third encoder includes a number of third encoders 40, which is equal to N, an output end of each of the third encoders 40 is connected to the constellation map mapper via one output selection switch, and an input end of each of the third encoders 40 is connected to an output end of one input selection switch, where N is greater than 1; as shown in Fig. 3, the composition structure of yet another multi-stage encoding device of an embodiment of the disclosure includes a first encoder 10, a second encoder 20 and a number N of third encoders 40;
the input end of a first one of the third encoders 401 is connected to the output end of the first input selection switch 41; the output end of the first one of the third encoders 401 is connected to the first input end of the second input selection switch 61;
an input end of an ith one of the third encoders 40i is connected to an output end of an ith input selection switch, where i is greater than or equal to 2 and less than N; an output end of the ith one of the third encoders 40i is connected to a first input end of an (i+1)th input selection switch; a number of the input ends of the ith input selection switch is equal to i+1; an (i+1)th input end of the ith input selection switch is connected to the data input end; second to ith input ends of the ith input selection switch are connected with the output ends of the first input selection switch to an (i-1)th input selection switch respectively;
an output end of an Nth one of the third encoders 40N is connected to the first input end of an (N+1)th input selection switch; a number of the input ends of the (N+1)th input selection switch is equal to N+2, and an (N+2)th input end of the (N+1)th input selection switch is connected to the data input end; second to (N+1)th input ends of the (N+1)th input selection switch are connected to the output ends of the first input selection switch to an Nth input selection switch respectively; an output end of the (N+1)th input selection switch is connected to the input end of the second encoder 20; wherein the Nth input end is expressed by N-1.

In an embodiment, the first encoder is the RS encoder, the second encoder is the LDPC encoder, and the third encoder is the Convolution encoder, the Turbo encoder, or multiple parity check code encoders other than the LDPC encoder.

An embodiment of the disclosure further provides a method for implementing a multi-stage encoding device, in which an input selection switch and an output selection switch are provided between input and output ends of a first encoder and a second encoder; as shown in Fig. 4, the basic implementation flow of the method includes the following steps.

Step 101: the first encoder and the second encoder are enabled to encode in parallel or in series by controlling the output selection switch and the input selection switch;
specifically, when the output end of the first encoder is connected to the constellation map mapper by the output selection switch, and the input end of the second encoder is connected to the data input end by the input selection switch, the first encoder and the second encoder encode in parallel; that is, the data encoded by the first encoder enters the second encoder, and is output after being encoded by the second encoder;
when the output end of the output selection switch is connected to the input end of the input selection switch to enable the output end of the first encoder and the input end of the second encoder to be connected, the first encoder and the second encoder encode in parallel; that is, the data encoded by the first encoder and the data encoded by the second encoder are output separately;
the first encoder is the RS encoder, and the second encoder is the LDPC encoder.

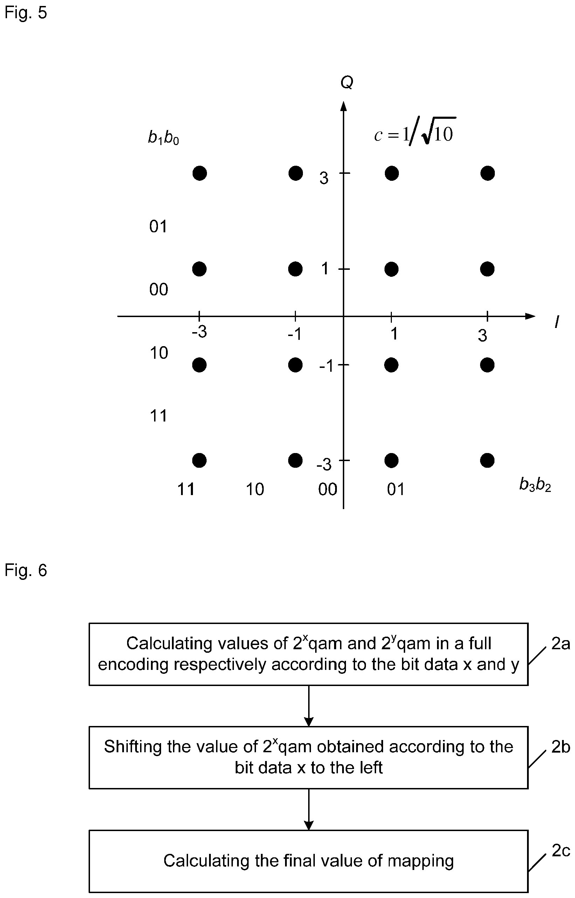

Step 102: the encoded data is mapped;
when the first encoder and the second encoder encode in series, and the encoded data is mapped, there is only the mapping mode of the second encoding, that is, the constellation map is directly mapped; specifically, by taking that a modulation mode is 16qam and the data after the second encoding is 4'b1101 for example, the implementation process of mapping the encoded data is as follows:
in the constellation map of 64qam (0, 4) shown in Fig. 5, two high bits 2'b11 correspond to the bit b3b2 at the lower right corner of Fig. 5, and the bit b3b2 corresponds to four constellation points in the first column on the left of Fig. 4; two low bits 2'b01 correspond to the bit b1b0 at the upper left corner of Fig. 4, and the bit b1b0 corresponds to four constellation points in the first line on the top of Fig. 5; the intersection point of the first column on the left and the first line on the top is the value obtained after mapping the data 4'b1101; the coordinate value of I axis corresponding to the intersection point is -3, and the coordinate value of Q axis corresponding to the intersection point is 3; the modulated symbol of the data 4'b1101 is (-3, 3).

When the first encoder and the second encoder are connected in parallel and the encoded data is mapped, it is necessary to first map the data after the first encoding and the second encoding respectively, calculate two different mapping results, and finally calculate a corresponding point in the constellation map;
specifically, for the quadrature amplitude (2^{M}QAM) modulation mode, each constellation point contains M bits, assuming that M=X+Y There are totally 2^{M} constellation points in the constellation map, the 2^{M} constellation points are divided into 2^{Y} constellation point subsets, and each subset contains 2^{X} constellation points. For each constellation point, Y bits in the M bits data are filled with information bit data after the LDPC encoding, at the same time the Y bits can also be used for identifying a constellation point subset, and this portion of bits are also called a subset index; the rest X bits are filled with RS information bit data not encoded, at the same time the X bits can also be used for identifying a certain constellation point in the subset. Although the bit data not encoded is not protected by encoding, the distance between the constellation points in the subset can become very large by providing the constellation map, so the noise resisting capability of the bit data not encoded is enhanced. QAMY represents a corresponding constellation map mapping table when the Y bits after the LDPC encoding are modulated, and QAMX represents a corresponding constellation map mapping table when the X bits after the RS encoding are modulated.

As shown in Fig. 6, the basic flow that the first encoder and the second encoder are connected in parallel and the encoded data is mapped includes the following steps.

Step 2a: values of 2^{X}qam and 2^{y}qam in a full encoding are calculated respectively according to x and y bits;
specifically, the structure in a full encoding can be multiplexed; for example, the values of 16qam and Quadrature Phase Shift Keying (QPSK) modulation under the LDPC encoding can be calculated respectively with 64qam(4, 2).

Step 2b: the value of 2^{x}qam obtained according to x bits is shifted to the left;
specifically, the number of bits shifted to the left is y/2, wherein y is an even number; when the value is shifted to the left, the right vacancy is filled with zero to obtain a shift amount of a value of a basic unit.

Step 2c: the final value of mapping is calculated;
specifically, the obtained shift amount and the value of 2^{y}qam obtained according to y bits are added to obtain the final value of mapping.

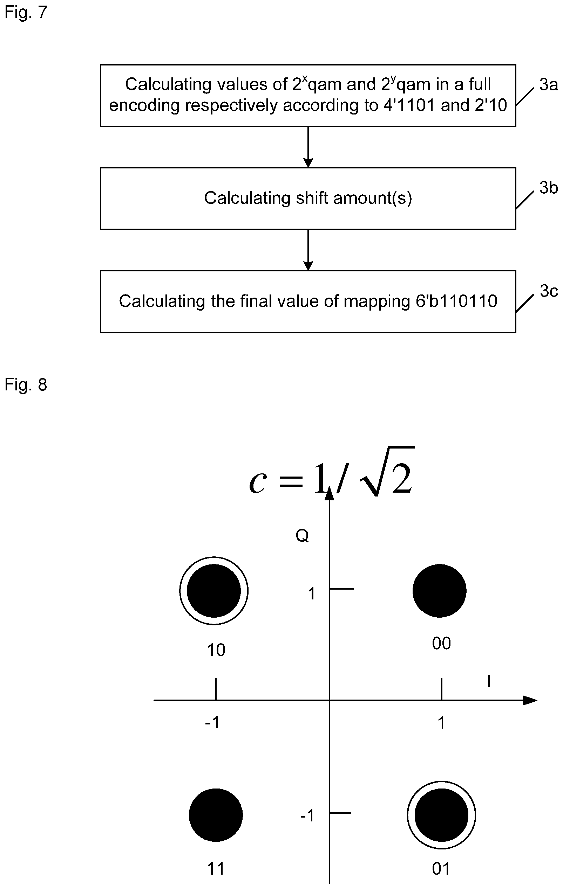

By taking that the RS encoder and the LDPC encoder are connected in parallel, the modulation mode is 64qam (4, 2), and the encoded data is 6'b110110 for example, if x=4'1101 and y=2'10, as shown in Fig. 7, the detailed implementation flow of mapping the encoded data includes the following steps.

Step 3a: values of 2^{X}qam and 2^{y}qam in a full encoding are calculated respectively according to 4'1101 and 2'10;
specifically, according to the calculation of Step 102, the value in the constellation map in Fig. 4 corresponding to x=4'b1101 is (-3, 3), and the value in the constellation map of qpsk (0, 2) in Fig. 7 corresponding to y=2'b10 is (-1, 1).

Step 3b: the shift amount is calculated;
specifically, y is 2 bits, and y/2=1; so the value obtained according to x=4'1101 is shifted by one bit to the left, which is equivalent to multiplying the value by 2, that is, -3x2=-6, and 3x2=6; so the calculated shift amounts are -6 and 6.

Step 3c: the final value of mapping 6'b110110 is calculated;
specifically, the shift amounts -6 and 6 are added to the value (-1, 1) in the constellation map of qpsk (0, 2) in Fig. 8 corresponding to 2'b10 respectively, so as to obtain a constellation point coordinate (-7, 7) of the data 6'b110110, namely the modulated symbol of the data 6'b110110 is (-7, 7).

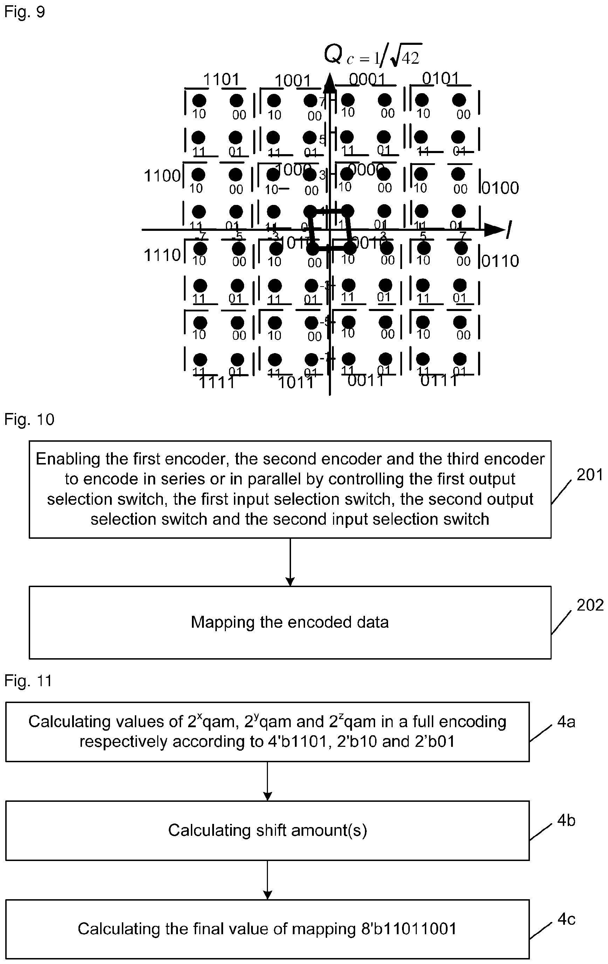

It can be seen that for multi-stage encoding, the basic unit of the constellation map is the constellation map corresponding to y, and the units of y are arranged to different positions according to x; Fig. 9 is the constellation map of 64qam (4, 2) whose basic unit is qpsk (0, 2) in Fig. 7; the point connected by a solid line in Fig. 8 is the original position of qpsk (0, 2), and the units at different positions are shifts from the original position of qpsk (0, 2); a shift value is decided by x in (x, y), and is equal to the index*2^{(y/2)} in a full encoding corresponding to x.

An embodiment of the disclosure further provides another method for implementing a multi-stage encoding device, in which a first output selection switch and a first input selection switch are provided between input and output ends of a first encoder and a third encoder; a second output selection switch and a second input selection switch are provided between input and output ends of the third encoder and a second encoder; as shown in Fig. 10, the basic implementation flow of the method includes the following steps.

Step 201: the first encoder, the second encoder and the third encoder are enabled to encode in series or in parallel by controlling the first output selection switch, the first input selection switch, the second output selection switch and the second input selection switch;
the third encoder includes a number of third encoders, which is equal to N, an output end of each of the third encoders is connected to the constellation map mapper via one output selection switch, and an input end of each of the third encoders is connected to an output end of one input selection switch, where N is greater than 1,;
the first encoder, the second encoder and the number N of third encoders are enabled to encode in parallel or in series by controlling each input selection switch and each output selection switch;
here, the first encoder is the RS encoder, the second encoder is the LDPC encoder, and the third encoder is the Convolution encoder, the Turbo encoder, or multiple parity check code encoders other than the LDPC encoder.

Step 202: the encoded data is mapped;
specifically, when the encoded data is output in series and the encoded data is mapped, there is only the mapping mode of the LDPC encoding, that is, the constellation map is directly mapped; when the encoded data is output in parallel and the encoded data is mapped, it is necessary to first map the data encoded by each encoder respectively, calculate all the mapping results, and finally calculate corresponding points in the constellation map.

By taking that the RS encoder, the Convolution encoder and the LDPC encoder are connected in parallel, the modulation mode is 256qam (4, 2, 2) and the data is 8'b11011001 for example, if x=4'b1101, y=2'b10 and z=2'b01, as shown in Fig. 11, the implementation flow of mapping the encoded data includes the following steps.

Step 4a: values of 2^{x}qam, 2^{y}qam and 2^{z}qam in a full encoding are calculated respectively according to 4'b1101, 2'b10 and 2'b01;
specifically, according to the calculation of Step 102, the value in the constellation map in Fig. 4 corresponding to x=4'b1101 is (-3, 3), the value in qpsk (0, 2) in Fig. 7 corresponding to y=2'b10 is (-1, 1), and the value in qpsk (0, 2) in Fig. 7 corresponding to z=2'b01 is (-1, 1).

Step 4b: the shift amount is calculated;
specifically, the first shift amounts -6 and 6 are obtained by performing the same processing as that in Step b on the values obtained by mapping x and y;
z is 2 bits, and z/2=1; so, shifting by one bit to the left is equivalent to multiplying the first shift amounts by 2, that is, -6x2=-12, and 6x2=12; so the calculated shift amounts are -12 and 12.

Step 4c: the final value of mapping 8'b11011001 is calculated;
specifically, the shift amounts -12 and 12 are added to the value (-1, 1) in qpsk (0, 2) in Fig. 7 corresponding to 2'b01 respectively, so as to obtain a constellation point coordinate (-13, 13) of the data 8'b11011001.

Note that the multi-stage encoding device includes N third encoders, if N is greater than or equal to 2, the same recursion mode as recited in Step 4c would be adopted to perform the modulation.

It can be seen that the method for implementing a multi-stage encoding modulation device provided by an embodiment of the disclosure supports a full encoding modulation mode and a parallel encoding modulation mode; in the full encoding modulation mode, the data entering the constellation map mapper is the data after the LDPC encoding, and the modulation mode includes 11 full encoding modulation modes from qpsk to 4096QAM; in the parallel encoding modulation mode, a part of the data entering the constellation map mapper is the data after multiple encoding modes, and other than the 11 full encoding modulation modes from qpsk to 4096QAM, part encoding modulation modes of the 11 full encoding modulation modes are also included, such as qpsk (1, 1), 16qam (2, 2), 32qam (3, 2), 32qam (2, 3), 64qam (4, 2), 64QAM (2, 4), 4096qam (10, 2), 4096qam (2, 10); so the modulation mode is flexible. At the same time, the multi-stage encoding device of an embodiment of the disclosure has a simple structure, reduces the design complexity by multiplexing circuits in different modulation modes, and reduces hardware resources; besides, the output mapping symbol rate can be matched to the extent that a full-rate output can be supported, so the demand of a high-throughput scenario can be met.

In the embodiment of the disclosure, if the message transmission method is implemented in a form of software function modules, and the software function modules are sold or used as independent products, they can also be stored in a computer readable storage medium. Based on this understanding, the technical solutions of the embodiments of the disclosure in the nature or with the part making a contribution to the prior art can be embodied in the form of a software product; the computer software product is stored in a storage medium and includes a number of instructions to cause a computer device (which may be a personal computer, a server or a network device, etc.) perform all or part of the method in each of the embodiments of the disclosure. The above-described storage medium includes a USB flash disk, a mobile hard disk, a Read Only Memory (ROM), a magnetic disk or a compact disc, and various other media which can store program codes. In this way, the embodiment of the disclosure is not limited to any particular combination of hardware and software.

Correspondingly, an embodiment of the disclosure further provides a computer storage medium in which a computer program is stored, the computer program is used for performing the above methods for implementing the multi-stage encoding device according to the embodiment of the disclosure.

What are described above are only the preferred embodiments of the disclosure and not intended to limit the scope of protection of the disclosure.

## Claims

1. A multi-stage encoding device comprising a first encoder (10) and a second encoder (20),
wherein an input end of the first encoder is connected to a data input end, an output end of the first encoder is connected to a constellation mapper (30) via an output selection switch (11), and the output end of the first encoder is connected to a first input end of an input selection switch (21),
wherein a second input end of the input selection switch is connected to the data input end, and an output end of the input selection switch is connected to an input end of the second encoder; an output end of the second encoder is connected to the constellation mapper, and
wherein an on/off state of the output selection switch enables the input selection switch to switch on different input ends,
wherein
when the output selection switch is in the on state, the input selection switch switches the second input end on, and the first encoder and the second encoder are connected in parallel, and a part of the data entering the constellation mapper is encoded by the first encoder and a remaining part of the data entering the constellation mapper is encoded separately by the second encoder; and
when the output selection switch is in the off state, the input selection switch switches the first input end on, and the first encoder and the second encoder are connected in series, and the data entering the constellation mapper is the data after being encoded serially by the first encoder and the second encoder.

2. The multi-stage encoding device according to claim 1, wherein the first encoder is a Reed-Solomon, RS, encoder, and the second encoder is a Low Density Parity Check Code, LDPC, encoder.

3. The multi-stage encoding device according to claim 1, further comprising at least one third encoder (40),
wherein the output selection switch includes a first output selection switch (31) and a second output selection switch (51) and the input selection switch includes a first input selection switch (41) and a second input selection switch (61), an output end of the first encoder is connected to the constellation mapper via the first output selection switch, and the output end of the first encoder is connected to a first input end of the first input selection switch,
wherein a second input end of the first input selection switch is connected to the data input end, and an output end of the first input selection switch is connected to an input end of the third encoder and a second input end of the second input selection switch; an output end of the third encoder is connected to the constellation mapper via the second output selection switch, and the output end of the third encoder is connected to a first input end of the second input selection switch,
wherein a third input end of the second input selection switch is connected to the data input end, and an output end of the second input selection switch is connected to an input end of the second encoder, and
an on/off state of the first output selection switch, an on/off state of the second output selection switch, and different input ends switched on by the first input selection switch enable the second input selection switch to switch on different input ends.

4. The multi-stage encoding device according to claim 3, wherein
when the first output selection switch is in the on state, the first input selection switch switches the second input end on, the second output selection switch is in the on state, the second input selection switch switches the third input end on, and the first encoder, the second encoder and the third encoder are connected in parallel; or
when the first output selection switch is in the off state, the first input selection switch switches the first input end on, the second output selection switch is in the on state, the second input selection switch switches the third input end on, and the first encoder and the third encoder are connected in series with each other and are connected in parallel with the second encoder; or
when the first output selection switch is in the off state, the first input selection switch switches the first input end on, the second output selection switch is in the off state, the second input selection switch switches the first input end on, and the first encoder, the second encoder and the third encoder are connected in series; or
when the first output selection switch is in the on state, the first input selection switch switches the second input end on, the second output selection switch is in the off state, the second input selection switch switches the first input end on, and the second encoder and the third encoder are connected in series with each other and are connected in parallel with the first encoder; or
when the first output selection switch is in the off state, the first input selection switch switches the first input end on, the second output selection switch is in the off state, the second input selection switch switches the second input end on, and the first encoder and the second encoder are connected in series; or
when the first output selection switch is in the on state, the first input selection switch switches the second input end on, the second output selection switch is in the off state, the second input selection switch switches the third input end on, and the first encoder and the second encoder are connected in parallel; or
when the first output selection switch is in the off state, the first input selection switch switches the second input end on, the second output selection switch is in the off state, the second input selection switch switches the first input end on, and the second encoder and the third encoder are connected in series; or
when the first output selection switch is in the off state, the first input selection switch switches the second input end on, the second output selection switch is in the on state, the second input selection switch switches the third input end on, and the second encoder and the third encoder are connected in parallel; or
when the first output selection switch is in the off state, the first input selection switch switches the first input end on, the second output selection switch is in the on state, the second input selection switch switches the first input end or the second input end on, and the first encoder and the third encoder are connected in series; or
when the first output selection switch is in the on state, the first input selection switch switches the second input end on, the second output selection switch is in the on state, the second input selection switch switches the first input end or the second input end on, and the first encoder and the third encoder are connected in parallel.

5. The multi-stage encoding device according to claim 4, wherein the third encoder includes a number of third encoders, which is equal to N, for each of the third encoders, an output end of said third encoder is connected to the constellation mapper via a respective output selection switch, and an input end of said third encoder is connected to an output end of a respective input selection switch, wherein N is greater than 1;
an input end of a first one of the third encoders is connected to the output end of the first input selection switch, and an output end of the first one of the third encoders is connected to the first input end of the second input selection switch;
an input end of an ith one of the third encoders is connected to an output end of an ith input selection switch, wherein i is greater than or equal to 2 and less than N; an output end of the ith one of the third encoders is connected to a first input end of an (i+1)th input selection switch; a number of the input ends of the ith input selection switch is equal to i+1, an (i+1)th input end of the ith input selection switch is connected to the data input end; second to ith input ends of the ith input selection switch are connected with output ends of the first input selection switch to an (i-1)th input selection switch respectively; and
an output end of an Nth one of the third encoders is connected to a first input end of an (N+1)th input selection switch; a number of the input ends of the (N+1)th input selection switch is equal to N+2, and an (N+2)th input end of the (N+1)th input selection switch is connected to the data input end; second to (N+1)th input ends of the (N+1)th input selection switch are connected to output ends of the first to Nth input selection switches respectively; an output end of the (N+1)th input selection switch is connected to the input end of the second encoder.

6. The multi-stage encoding device according to any one of claims 3 to 5, wherein the first encoder is a Reed-Solomon, RS, encoder, the second encoder is a Low Density Parity Check Code, LDPC, encoder, and the third encoder is a convolution encoder or a Turbo encoder.

7. A method for implementing a multi-stage encoding device, wherein the method comprises:
providing an input selection switch and an output selection switch between input and output ends of first and second encoders,
wherein the input end of the first encoder is connected to a data input end, the output end of the first encoder is connected to a constellation mapper via the output selection switch, and the output end of the first encoder is connected to a first input end of the input selection switch,
wherein a second input end of the input selection switch is connected to the data input end, and an output end of the input selection switch is connected to the input end of the second encoder; the output end of the second encoder is connected to the constellation mapper, and
wherein an on/off state of the output selection switch enables the input selection switch to switch on different input ends,
wherein when the output selection switch is in the on state, the input selection switch switches the second input end on, and the first encoder and the second encoder are connected in parallel, and a part of the data entering the constellation mapper is encoded by the first encoder and a remaining part of the data entering the constellation mapper is encoded separately by the second encoder; or
when the output selection switch is in the off state, the input selection switch switches the first input end on, and the first encoder and the second encoder are connected in series, and the data entering the constellation mapper is the data after being encoded serially by the first encoder and the second encoder.

8. The method for implementing the multi-stage encoding device according to claim 7, wherein the first encoder is a Reed-Solomon, RS, encoder, and the second encoder is a Low Density Parity Check Code, LDPC, encoder.

9. A method for implementing a multi-stage encoding device according to claim 7, wherein the method further comprises:
providing a first output selection switch and a first input selection switch between an input end and an output end of a first encoder and a third encoder;
providing a second output selection switch and a second input selection switch between an input end and an output end of the third encoder and a second encoder; and
enabling the first encoder, the second encoder and the third encoder to encode in series or in parallel by controlling the first output selection switch, the first input selection switch, the second output selection switch and the second input selection switch.

10. The method for implementing the multi-stage encoding device according to claim 9, wherein the third encoder includes a number of third encoders, which is equal to N, an output end of each of the third encoders is connected to a constellation mapper via a respective output selection switch, and an input end of each of the third encoders is connected to an output end of a respective input selection switch, wherein N is greater than 1; and
wherein said enabling comprises:
enabling the first encoder, the second encoder and the N third encoders to encode in parallel or in series by controlling each input selection switch and each output selection switch.

11. The method for implementing the multi-stage encoding device according to any one of claims 7 to 10, wherein the first encoder is a Reed-Solomon, RS, encoder, the second encoder is a Low Density Parity Check Code, LDPC, encoder, and the third encoder is a convolution encoder or a Turbo encoder.

12. A computer-readable storage medium comprising instructions which, when executed by a computer, cause the computer to carry out the method of any one of claims 7 to 11.

## Patentansprüche

1. Mehrstufige Codierungsvorrichtung, umfassend einen ersten Codierer (10) und einen zweiten Codierer (20),
wobei ein Eingangsende des ersten Codierers mit einem Dateneingangsende verbunden ist, ein Ausgangsende des ersten Codierers über einen Ausgangswahlschalter (11) mit einer Konstellationsabbildungseinrichtung (30) verbunden ist und das Ausgangsende des ersten Codierers mit einem ersten Eingangsende eines Eingangswahlschalters (21) verbunden ist,
wobei ein zweites Eingangsende des Eingangswahlschalters mit dem Dateneingangsende verbunden ist und ein Ausgangsende des Eingangswahlschalters mit einem Eingangsende des zweiten Codierers verbunden ist; ein Ausgangsende des zweiten Codierers mit der Konstellationsabbildungseinrichtung verbunden ist und
wobei ein An-/Aus-Zustand des Ausgangswahlschalters es dem Eingangswahlschalter ermöglicht, unterschiedliche Eingangsenden anzuschalten,
wobei
wenn sich der Ausgangswahlschalter in dem angeschalteten Zustand befindet, der Eingangswahlschalter das zweite Eingangsende anschaltet und der erste Codierer und der zweite Codierer parallelgeschaltet sind und ein Teil der in die Konstellationsabbildungseinrichtung einfließenden Daten von dem ersten Codierer codiert wird und ein verbleibender Teil der in die Konstellationsabbildungseinrichtung einfließenden Daten separat von dem zweiten Codierer codiert wird; und
wenn sich der Ausgangswahlschalter in dem ausgeschalteten Zustand befindet, der Eingangswahlschalter das erste Eingangsende anschaltet und der erste Codierer und der zweite Codierer in Reihe geschaltet sind und es sich bei den in die Konstellationsabbildungseinrichtung einfließenden Daten um die Daten handelt, nachdem sie in Reihe von dem ersten Codierer und dem zweiten Codierer codiert wurden.

2. Mehrstufige Codierungsvorrichtung nach Anspruch 1, wobei der erste Codierer ein Reed-Solomon-Codierer (RS-Codierer) ist und der zweite Codierer ein Low-Density-Parity-Check-Code-Codierer (LDPC-Codierer) ist.

3. Mehrstufige Codierungsvorrichtung nach Anspruch 1, ferner umfassend mindestens einen dritten Codierer (40),
wobei der Ausgangswahlschalter einen ersten Ausgangswahlschalter (31) und einen zweiten Ausgangswahlschalter (51) beinhaltet und der Eingangswahlschalter einen ersten Eingangswahlschalter (41) und einen zweiten Eingangswahlschalter (61) beinhaltet, ein Ausgangsende des ersten Codierers über den ersten Ausgangswahlschalter mit der Konstellationsabbildungseinrichtung verbunden ist und das Ausgangsende des ersten Codierers mit einem ersten Eingangsende des ersten Eingangswahlschalter verbunden ist,
wobei ein zweites Eingangsende des ersten Eingangswahlschalters mit dem Dateneingangsende verbunden ist und ein Ausgangsende des ersten Eingangswahlschalters mit einem Eingangsende des dritten Codierers und einem zweiten Eingangsende des zweiten Eingangswahlschalters verbunden ist; ein Ausgangsende des dritten Codierers über den zweiten Ausgangswahlschalter mit der Konstellationsabbildungseinrichtung verbunden ist und das Ausgangsende des dritten Codierers mit einem ersten Eingangsende des zweiten Eingangswahlschalters verbunden ist,
wobei ein drittes Eingangsende des zweiten Eingangswahlschalters mit dem Dateneingangsende verbunden ist und ein Ausgangsende des zweiten Eingangswahlschalters mit einem Eingangsende des zweiten Codierers verbunden ist und
ein An-/Aus-Zustand des ersten Ausgangswahlschalters, ein An-/Aus-Zustand des zweiten Ausgangswahlschalters und unterschiedliche Eingangsenden, die von dem ersten Eingangswahlschalter angeschaltet wurden, es dem zweiten Eingangswahlschalter ermöglichen, unterschiedliche Eingangsenden anzuschalten.

4. Mehrstufige Codierungsvorrichtung nach Anspruch 3, wobei
wenn sich der erste Ausgangswahlschalter in dem angeschalteten Zustand befindet, der erste Eingangswahlschalter das zweite Eingangsende anschaltet, sich der zweite Ausgangswahlschalter in dem angeschalteten Zustand befindet, der zweite Eingangswahlschalter das dritte Eingangsende anschaltet und der erste Codierer, der zweite Codierer und der dritte Codierer parallelgeschaltet sind; oder
wenn sich der erste Ausgangswahlschalter in dem ausgeschalteten Zustand befindet, der erste Eingangswahlschalter das erste Eingangsende anschaltet, sich der zweite Ausgangswahlschalter in dem angeschalteten Zustand befindet, der zweite Eingangswahlschalter das dritte Eingangsende anschaltet und der erste Codierer und der dritte Codierer miteinander in Reihe geschaltet und mit dem zweiten Codierer parallelgeschaltet sind; oder
wenn sich der erste Ausgangswahlschalter in dem ausgeschalteten Zustand befindet, der erste Eingangswahlschalter das erste Eingangsende anschaltet, sich der zweite Ausgangswahlschalter in dem ausgeschalteten Zustand befindet, der zweite Eingangswahlschalter das erste Eingangsende anschaltet und der erste Codierer, der zweite Codierer und der dritte Codierer in Reihe geschaltet sind; oder
wenn sich der erste Ausgangswahlschalter in dem angeschalteten Zustand befindet, der erste Eingangswahlschalter das zweite Eingangsende anschaltet, sich der zweite Ausgangswahlschalter in dem ausgeschalteten Zustand befindet, der zweite Eingangswahlschalter das erste Eingangsende anschaltet und der zweite Codierer und der dritte Codierer miteinander in Reihe geschaltet und mit dem ersten Codierer parallelgeschaltet sind; oder
wenn sich der erste Ausgangswahlschalter in dem ausgeschalteten Zustand befindet, der erste Eingangswahlschalter das erste Eingangsende anschaltet, sich der zweite Ausgangswahlschalter in dem ausgeschalteten Zustand befindet, der zweite Eingangswahlschalter das zweite Eingangsende anschaltet und der erste Codierer und der zweite Codierer in Reihe geschaltet sind; oder
wenn sich der erste Ausgangswahlschalter in dem angeschalteten Zustand befindet, der erste Eingangswahlschalter das zweite Eingangsende anschaltet, sich der zweite Ausgangswahlschalter in dem ausgeschalteten Zustand befindet, der zweite Eingangswahlschalter das dritte Eingangsende anschaltet und der erste Codierer und der zweite Codierer parallelgeschaltet sind; oder
wenn sich der erste Ausgangswahlschalter in dem ausgeschalteten Zustand befindet, der erste Eingangswahlschalter das zweite Eingangsende anschaltet, sich der zweite Ausgangswahlschalter in dem ausgeschalteten Zustand befindet, der zweite Eingangswahlschalter das erste Eingangsende anschaltet und der zweite Codierer und der dritte Codierer in Reihe geschaltet sind; oder
wenn sich der erste Ausgangswahlschalter in dem ausgeschalteten Zustand befindet, der erste Eingangswahlschalter das zweite Eingangsende anschaltet, sich der zweite Ausgangswahlschalter in dem angeschalteten Zustand befindet, der zweite Eingangswahlschalter das dritte Eingangsende anschaltet und der zweite Codierer und der dritte Codierer parallelgeschaltet sind; oder
wenn sich der erste Ausgangswahlschalter in dem ausgeschalteten Zustand befindet, der erste Eingangswahlschalter das erste Eingangsende anschaltet, sich der zweite Ausgangswahlschalter in dem angeschalteten Zustand befindet, der zweite Eingangswahlschalter das erste Eingangsende oder das zweite Eingangsende anschaltet und der erste Codierer und der dritte Codierer in Reihe geschaltet sind; oder
wenn sich der erste Ausgangswahlschalter in dem angeschalteten Zustand befindet, der erste Eingangswahlschalter das zweite Eingangsende anschaltet, sich der zweite Ausgangswahlschalter in dem angeschalteten Zustand befindet, der zweite Eingangswahlschalter das erste Eingangsende oder das zweite Eingangsende anschaltet und der erste Codierer und der dritte Codierer parallelgeschaltet sind.

5. Mehrstufige Codierungsvorrichtung nach Anspruch 4, wobei der dritte Codierer eine Anzahl an dritten Codierern beinhaltet, die N entspricht, für jeden der dritten Codierer ein Ausgangsende des dritten Codierers über einen jeweiligen Ausgangswahlschalter mit der Konstellationsabbildungseinrichtung verbunden ist und ein Eingangsende des dritten Codierers mit einem Ausgangsende eines jeweiligen Eingangswahlschalters verbunden ist, wobei N größer als 1 ist;
wobei ein Eingangsende eines ersten der dritten Codierer mit dem Ausgangsende des ersten Eingangswahlschalters verbunden ist und ein Ausgangsende des ersten der dritten Codierer mit dem ersten Eingangsende des zweiten Eingangswahlschalters verbunden ist;
wobei ein Eingangsende eines i-ten der dritten Codierer mit einem Ausgangsende eines i-ten Eingangswahlschalters verbunden ist, wobei i größer oder gleich 2 und kleiner als N ist; ein Ausgangsende des i-ten der dritten Codierer mit einem ersten Eingangsende eines (i+1)-ten Eingangswahlschalters verbunden ist; eine Anzahl der Eingangsenden des i-ten Eingangswahlschalters i+1 entspricht, ein (i+1)-tes Eingangsende des i-ten Eingangswahlschalters mit dem Dateneingangsende verbunden ist; das zweite bis i-te Eingangsende des i-ten Eingangswahlschalters mit Ausgangsenden des ersten Eingangswahlschalters jeweils zu einem (i-1)-ten Eingangswahlschalter verbunden sind; und
wobei ein Ausgangsende eines N-ten der dritten Codierer mit einem ersten Eingangsende eines (N+1)-ten Eingangswahlschalters verbunden ist; eine Anzahl der Eingangsenden des (N+1)-ten Eingangswahlschalters N+2 entspricht und ein (N+2)-tes Eingangsende des (N+1)-ten Eingangswahlschalters mit dem Dateneingangsende verbunden ist; das zweite bis (N+1)-te Eingangsende des (N+1)-ten Eingangswahlschalters jeweils mit Ausgangsenden des ersten bis N-ten Eingangswahlschalters verbunden sind; ein Ausgangsende des (N+1)-ten Eingangswahlschalters mit dem Eingangsende des zweiten Codierers verbunden ist.

6. Mehrstufige Codierungsvorrichtung nach einem der Ansprüche 3 bis 5, wobei der erste Codierer ein Reed-Solomon-Codierer (RS-Codierer) ist, der zweite Codierer ein Low-Density-Parity-Check-Code-Codierer (LDPC-Codierer) ist und der dritte Codierer ein Faltungscodierer oder Turbocodierer ist.

7. Verfahren zum Implementieren einer mehrstufigen Codierungsvorrichtung, wobei das Verfahren Folgendes umfasst:
Bereitstellen eines Eingangswahlschalters und eines Ausgangswahlschalters zwischen Eingangs- und Ausgangsenden eines ersten und eines zweiten Codierers;
wobei das Eingangsende des ersten Codierers mit einem Dateneingangsende verbunden ist, das Ausgangsende des ersten Codierers über den Ausgangswahlschalter mit einer Konstellationsabbildungseinrichtung verbunden ist und das Ausgangsende des ersten Codierers mit einem ersten Eingangsende des Eingangswahlschalters verbunden ist,
wobei ein zweites Eingangsende des Eingangswahlschalters mit dem Dateneingangsende verbunden ist und ein Ausgangsende des Eingangswahlschalters mit dem Eingangsende des zweiten Codierers verbunden ist; das Ausgangsende des zweiten Codierers mit der Konstellationsabbildungseinrichtung verbunden ist und
wobei ein An-/Aus-Zustand des Ausgangswahlschalters es dem Eingangswahlschalter ermöglicht, unterschiedliche Eingangsenden anzuschalten,
wobei, wenn sich der Ausgangswahlschalter in dem angeschalteten Zustand befindet, der Eingangswahlschalter das zweite Eingangsende anschaltet und der erste Codierer und der zweite Codierer parallelgeschaltet sind und ein Teil der in die Konstellationsabbildungseinrichtung einfließenden Daten von dem ersten Codierer codiert wird und ein verbleibender Teil der in die Konstellationsabbildungseinrichtung einfließenden Daten separat von dem zweiten Codierer codiert wird; oder
wenn sich der Ausgangswahlschalter in dem ausgeschalteten Zustand befindet, der Eingangswahlschalter das erste Eingangsende anschaltet und der erste Codierer und der zweite Codierer in Reihe geschaltet sind und es sich bei den in die Konstellationsabbildungseinrichtung einfließenden Daten um die Daten handelt, nachdem sie in Reihe von dem ersten Codierer und dem zweiten Codierer codiert wurden.

8. Verfahren zum Implementieren der mehrstufigen Codierungsvorrichtung nach Anspruch 7, wobei der erste Codierer ein Reed-Solomon-Codierer (RS-Codierer) ist und der zweite Codierer ein Low-Density-Parity-Check-Code-Codierer (LDPC-Codierer) ist.

9. Verfahren zum Implementieren einer mehrstufigen Codierungsvorrichtung nach Anspruch 7, wobei das Verfahren ferner Folgendes umfasst:
Bereitstellen eines ersten Ausgangswahlschalters und eines ersten Eingangswahlschalters zwischen einem Eingangsende und einem Ausgangsende eines ersten Codierers und eines dritten Codierers;
Bereitstellen eines zweiten Ausgangswahlschalters und eines zweiten Eingangswahlschalters zwischen einem Eingangsende und einem Ausgangsende des dritten Codierers und eines zweiten Codierers; und
Ermöglichen, dass der erste Codierer, der zweite Codierer und der dritte Codierer in Reihe oder parallel codieren, durch Steuern des ersten Ausgangswahlschalters, des ersten Eingangswahlschalters, des zweiten Ausgangswahlschalters und des zweiten Eingangswahlschalters.

10. Verfahren zum Implementieren der mehrstufigen Codierungsvorrichtung nach Anspruch 9, wobei der dritte Codierer eine Anzahl an dritten Codierern beinhaltet, die N entspricht, ein Ausgangsende jedes der dritten Codierer über einen jeweiligen Ausgangswahlschalter mit einer Konstellationsabbildungseinrichtung verbunden ist und ein Eingangsende jedes der dritten Codierer mit einem Ausgangsende eines jeweiligen Eingangswahlschalters verbunden ist, wobei N größer als 1 ist; und
wobei das Ermöglichen Folgendes umfasst:
Ermöglichen, dass der erste Codierer, der zweite Codierer und die N dritten Codierer parallel oder in Reihe codieren, durch Steuern jedes Eingangswahlschalters und jedes Ausgangswahlschalters.

11. Verfahren zum Implementieren der mehrstufigen Codierungsvorrichtung nach einem der Ansprüche 7 bis 10, wobei der erste Codierer ein Reed-Solomon-Codierer (RS-Codierer) ist, der zweite Codierer ein Low-Density-Parity-Check-Code-Codierer (LDPC-Codierer) ist und der dritte Codierer ein Faltungscodierer oder Turbocodierer ist.

12. Computerlesbares Speichermedium, das Anweisungen umfasst, die bei Ausführung durch einen Computer den Computer dazu veranlassen, das Verfahren nach einem der Ansprüche 7 bis 11 auszuführen.

## Revendications

1. Dispositif d'encodage multi-étage comprenant un premier codeur (10) et un deuxième codeur (20),
dans lequel une extrémité d'entrée du premier codeur est connectée à une extrémité d'entrée de données, une extrémité de sortie du premier codeur est connectée à un dispositif de mappage de constellation (30) par l'intermédiaire d'un commutateur de sélection de sortie (11), et l'extrémité de sortie du premier codeur est connectée à une première extrémité d'entrée d'un commutateur de sélection d'entrée (21),
dans lequel une deuxième extrémité d'entrée du commutateur de sélection d'entrée est connectée à l'extrémité d'entrée de données, et une extrémité de sortie du commutateur de sélection d'entrée est connectée à une extrémité d'entrée du deuxième codeur ; une extrémité de sortie du deuxième codeur est connectée au dispositif de mappage de constellation, et
dans lequel un état activé/désactivé du commutateur de sélection de sortie permet au commutateur de sélection d'entrée d'activer différentes extrémités d'entrée,
dans lequel
lorsque le commutateur de sélection de sortie est à l'état activé, le commutateur de sélection d'entrée active la deuxième extrémité d'entrée, et le premier codeur et le deuxième codeur sont connectés en parallèle, et une partie des données entrant dans le dispositif de mappage de constellation est codée par le premier codeur et une partie restante des données entrant dans le dispositif de mappage de constellation est codée séparément par le deuxième codeur ; et
lorsque le commutateur de sélection de sortie est à l'état désactivé, le commutateur de sélection d'entrée active la première extrémité d'entrée, et le premier codeur et le deuxième codeur sont connectés en série, et les données entrant dans le dispositif de mappage de constellation sont les données après qu'elles ont été codées en série par le premier codeur et le deuxième codeur.

2. Dispositif d'encodage multi-étage selon la revendication 1, dans lequel le premier codeur est un codeur de Reed-Solomon, RS, et le deuxième codeur est un codeur de code de contrôle de parité à faible densité, LDPC.

3. Dispositif d'encodage multi-étage selon la revendication 1, comprenant en outre au moins un troisième codeur (40),
dans lequel le commutateur de sélection de sortie comporte un premier commutateur de sélection de sortie (31) et un second commutateur de sélection de sortie (51) et le commutateur de sélection d'entrée comporte un premier commutateur de sélection d'entrée (41) et un second commutateur de sélection d'entrée (61), une extrémité de sortie du premier codeur est connectée au dispositif de mappage de constellation par l'intermédiaire du premier commutateur de sélection de sortie, et l'extrémité de sortie du premier codeur est connectée à une première extrémité d'entrée du premier commutateur de sélection d'entrée,
dans lequel une deuxième extrémité d'entrée du premier commutateur de sélection d'entrée est connectée à l'extrémité d'entrée de données, et une extrémité de sortie du premier commutateur de sélection d'entrée est connectée à une extrémité d'entrée du troisième codeur et à une deuxième extrémité d'entrée du second commutateur de sélection d'entrée ; une extrémité de sortie du troisième codeur est connectée au dispositif de mappage de constellation par l'intermédiaire du second commutateur de sélection de sortie, et l'extrémité de sortie du troisième codeur est connectée à une première extrémité d'entrée du second commutateur de sélection d'entrée,
dans lequel une troisième extrémité d'entrée du second commutateur de sélection d'entrée est connectée à l'extrémité d'entrée de données, et une extrémité de sortie du second commutateur de sélection d'entrée est connectée à une extrémité d'entrée du deuxième codeur, et
un état activé/désactivé du premier commutateur de sélection de sortie, un état activé/désactivé du second commutateur de sélection de sortie, et différentes extrémités d'entrée activées par le premier commutateur de sélection d'entrée permettent au second commutateur de sélection d'entrée d'activer différentes extrémités d'entrée.

4. Dispositif d'encodage multi-étage selon la revendication 3, dans lequel
lorsque le premier commutateur de sélection de sortie est à l'état activé, le premier commutateur de sélection d'entrée active la deuxième extrémité d'entrée, le second commutateur de sélection de sortie est à l'état activé, le second commutateur de sélection d'entrée active la troisième extrémité d'entrée, et le premier codeur, le deuxième codeur et le troisième codeur sont connectés en parallèle ; ou
lorsque le premier commutateur de sélection de sortie est à l'état désactivé, le premier commutateur de sélection d'entrée active la première extrémité d'entrée, le second commutateur de sélection de sortie est à l'état activé, le second commutateur de sélection d'entrée active la troisième extrémité d'entrée, et le premier codeur et le troisième codeur sont connectés l'un à l'autre en série et sont connectés en parallèle au deuxième codeur ; ou
lorsque le premier commutateur de sélection de sortie est à l'état désactivé, le premier commutateur de sélection d'entrée active la première extrémité d'entrée, le second commutateur de sélection de sortie est à l'état désactivé, le second commutateur de sélection d'entrée active la première extrémité d'entrée, et le premier codeur, le deuxième codeur et le troisième codeur sont connectés en série ; ou
lorsque le premier commutateur de sélection de sortie est à l'état activé, le premier commutateur de sélection d'entrée active la deuxième extrémité d'entrée, le second commutateur de sélection de sortie est à l'état désactivé, le second commutateur de sélection d'entrée active la première extrémité d'entrée, et le deuxième codeur et le troisième codeur sont connectés l'un à l'autre en série et sont connectés en parallèle au premier codeur ; ou
lorsque le premier commutateur de sélection de sortie est à l'état désactivé, le premier commutateur de sélection d'entrée active la première extrémité d'entrée, le second commutateur de sélection de sortie est à l'état désactivé, le second commutateur de sélection d'entrée active la deuxième extrémité d'entrée, et le premier codeur et le deuxième codeur sont connectés en série ; ou
lorsque le premier commutateur de sélection de sortie est à l'état activé, le premier commutateur de sélection d'entrée active la deuxième extrémité d'entrée, le second commutateur de sélection de sortie est à l'état désactivé, le second commutateur de sélection d'entrée active la troisième extrémité d'entrée, et le premier codeur et le deuxième codeur sont connectés en parallèle ; ou
lorsque le premier commutateur de sélection de sortie est à l'état désactivé, le premier commutateur de sélection d'entrée active la deuxième extrémité d'entrée, le second commutateur de sélection de sortie est à l'état désactivé, le second commutateur de sélection d'entrée active la première extrémité d'entrée, et le deuxième codeur et le troisième codeur sont connectés en série ; ou
lorsque le premier commutateur de sélection de sortie est à l'état désactivé, le premier commutateur de sélection d'entrée active la deuxième extrémité d'entrée, le second commutateur de sélection de sortie est à l'état activé, le second commutateur de sélection d'entrée active la troisième extrémité d'entrée, et le deuxième codeur et le troisième codeur sont connectés en parallèle ; ou
lorsque le premier commutateur de sélection de sortie est à l'état désactivé, le premier commutateur de sélection d'entrée active la première extrémité d'entrée, le second commutateur de sélection de sortie est à l'état activé, le second commutateur de sélection d'entrée active la première extrémité d'entrée ou la deuxième extrémité d'entrée, et le premier codeur et le troisième codeur sont connectés en série ; ou
lorsque le premier commutateur de sélection de sortie est à l'état activé, le premier commutateur de sélection d'entrée active la deuxième extrémité d'entrée, le second commutateur de sélection de sortie est à l'état activé, le second commutateur de sélection d'entrée active la première extrémité d'entrée ou la deuxième extrémité d'entrée, et le premier codeur et le troisième codeur sont connectés en parallèle.

5. Dispositif d'encodage multi-étage selon la revendication 4, dans lequel le troisième codeur comporte un nombre de troisièmes codeurs, qui est égal à N, pour chacun des troisièmes codeurs, une extrémité de sortie dudit troisième codeur est connectée au dispositif de mappage de constellation par l'intermédiaire d'un commutateur de sélection de sortie respectif, et une extrémité d'entrée dudit troisième codeur est connectée à une extrémité de sortie d'un commutateur de sélection d'entrée respectif, dans lequel N est supérieur à 1 ;
une extrémité d'entrée d'un premier des troisièmes codeurs est connectée à l'extrémité de sortie du premier commutateur de sélection d'entrée, et une extrémité de sortie du premier des troisièmes codeurs est connectée à la première extrémité d'entrée du second commutateur de sélection d'entrée ;
une extrémité d'entrée d'un i^{ème} des troisièmes codeurs est connectée à une extrémité de sortie d'un i^{ème} commutateur de sélection d'entrée, dans lequel i est supérieur ou égal à 2 et inférieur à N ; une extrémité de sortie du i^{ème} des troisièmes codeurs est connectée à une première extrémité d'entrée d'un (i + i)^{ème} commutateur de sélection d'entrée ; un nombre des extrémités d'entrée du i^{ème} commutateur de sélection d'entrée est égal à i + 1, une (i + 1)^{ème} extrémité d'entrée du i^{ème} commutateur de sélection d'entrée est connectée à l'extrémité d'entrée de données ; des deuxième à i^{ème} extrémités d'entrée du i^{ème} commutateur de sélection d'entrée sont connectées avec des extrémités de sortie du premier commutateur de sélection d'entrée à un (i - 1)^{ème} commutateur de sélection d'entrée respectivement ; et
une extrémité de sortie d'un N^{ème} des troisièmes codeurs est connectée à une première extrémité d'entrée d'un (N + 1)^{ème} commutateur de sélection d'entrée ; un nombre d'extrémités d'entrée du (N + 1)^{ème} commutateur de sélection d'entrée est égal à N + 2, et une (N + 2)^{ème} extrémité d'entrée du (N + 1)^{ème} commutateur de sélection d'entrée est connectée à l'extrémité d'entrée de données ; des deuxième à (N + 1)^{ème} extrémités d'entrée du (N + 1)^{ème} commutateur de sélection d'entrée sont connectées à des extrémités de sortie des premier à N^{ème} commutateurs de sélection d'entrée respectivement ; une extrémité de sortie du (N + 1)^{ème} commutateur de sélection d'entrée est connectée à l'extrémité d'entrée du deuxième codeur.

6. Dispositif d'encodage multi-étage selon l'une quelconque des revendications 3 à 5, dans lequel le premier codeur est un codeur de Reed-Solomon, RS, le deuxième codeur est un codeur de code de contrôle de parité à faible densité, LDPC, et le troisième codeur est un codeur de convolution ou un codeur Turbo.

7. Procédé de mise en œuvre d'un dispositif d'encodage multi-étage, le procédé comprenant :
la fourniture d'un commutateur de sélection d'entrée et d'un commutateur de sélection de sortie entre des extrémités d'entrée et de sortie des premier et deuxième codeurs,
dans lequel l'extrémité d'entrée du premier codeur est connectée à une extrémité d'entrée de données, l'extrémité de sortie du premier codeur est connectée à un dispositif de mappage de constellation par l'intermédiaire du commutateur de sélection de sortie, et l'extrémité de sortie du premier codeur est connectée à une première extrémité d'entrée du commutateur de sélection d'entrée,
dans lequel une deuxième extrémité d'entrée du commutateur de sélection d'entrée est connectée à l'extrémité d'entrée de données, et une extrémité de sortie du commutateur de sélection d'entrée est connectée à l'extrémité d'entrée du deuxième codeur ; l'extrémité de sortie du deuxième codeur est connectée au dispositif de mappage de constellation, et
dans lequel un état activé/désactivé du commutateur de sélection de sortie permet au commutateur de sélection d'entrée d'activer différentes extrémités d'entrée,
dans lequel lorsque le commutateur de sélection de sortie est à l'état activé, le commutateur de sélection d'entrée active la deuxième extrémité d'entrée, et le premier codeur et le deuxième codeur sont connectés en parallèle, et une partie des données entrant dans le dispositif de mappage de constellation sont codées par le premier codeur et une partie restante des données entrant dans le dispositif de mappage de constellation sont codées séparément par le deuxième codeur ; ou
lorsque le commutateur de sélection de sortie est à l'état désactivé, le commutateur de sélection d'entrée active la première extrémité d'entrée, et le premier codeur et le deuxième codeur sont connectés en série, et les données entrant dans le dispositif de mappage de constellation sont les données après qu'elles ont été codées en série par le premier codeur et le deuxième codeur.

8. Procédé de mise en œuvre du dispositif d'encodage multi-étage selon la revendication 7, dans lequel le premier codeur est un codeur de Reed-Solomon, RS, et le deuxième codeur est un codeur de code de contrôle de parité à faible densité, LDPC.

9. Procédé de mise en œuvre d'un dispositif d'encodage multi-étage selon la revendication 7, le procédé comprenant en outre :
la fourniture d'un premier commutateur de sélection de sortie et d'un premier commutateur de sélection d'entrée entre une extrémité d'entrée et une extrémité de sortie d'un premier codeur et d'un troisième codeur ;
la fourniture d'un second commutateur de sélection de sortie et d'un second commutateur de sélection d'entrée entre une extrémité d'entrée et une extrémité de sortie du troisième codeur et d'un deuxième codeur ; et
le fait de permettre l'encodage en série ou en parallèle par le premier codeur, le deuxième codeur et le troisième codeur en commandant le premier commutateur de sélection de sortie, le premier commutateur de sélection d'entrée, le second commutateur de sélection de sortie et le second commutateur de sélection d'entrée.

10. Procédé de mise en œuvre du dispositif d'encodage multi-étage selon la revendication 9, dans lequel le troisième codeur comporte un nombre de troisièmes codeurs, qui est égal à N, une extrémité de sortie de chacun des troisièmes codeurs est connectée à un dispositif de mappage de constellation par l'intermédiaire d'un commutateur de sélection de sortie respectif, et une extrémité d'entrée de chacun des troisièmes codeurs est connectée à une extrémité de sortie d'un commutateur de sélection d'entrée respectif, dans lequel N est supérieur à 1 ; et
dans lequel ledit encodage comprend :
le fait de permettre l'encodage en parallèle ou en série par le premier codeur, le deuxième codeur et les N troisièmes codeurs en commandant chaque commutateur de sélection d'entrée et chaque commutateur de sélection de sortie.

11. Procédé de mise en œuvre du dispositif d'encodage multi-étage selon l'une quelconque des revendications 7 à 10, dans lequel le premier codeur est un codeur de Reed-Solomon, RS, le deuxième codeur est un codeur de code de contrôle de parité à faible densité, LDPC, et le troisième codeur est un codeur de convolution ou un codeur Turbo.

12. Support de stockage lisible par ordinateur comprenant des instructions qui, lorsqu'elles sont exécutées par un ordinateur, amènent l'ordinateur à exécuter le procédé selon l'une quelconque des revendications 7 à 11.
